# EUROPEAN PATENT SPECIFICATION

(11) **EP 0 388 612 B1**
(45) Date of publication and mention of the grant of the patent: **30.11.1994**
(21) Application number: 90102164.2
(22) Date of filing: 03.02.1990
(51) Int. Cl.: H01L 21/314, H01L 21/20, H01L 21/265, H01L 29/70

(54) **Semiconductor device with self-aligned contact to buried subcollector**
Halbleitervorrichtung mit einem relativ zu einem vergrabenen Subkollektor selbstausgerichteten Kontakt
Dispositif semi-conducteur ayant un contact à alignement automatique avec un sous-collecteur enterré

(30) Priority: 24.03.1989 US 327627
(43) Date of publication of application: 26.09.1990
(73) Proprietor: International Business Machines Corporation, Armonk, N.Y. 10504 (US)
(72) Inventor: Harame, David L., Mohegan Lake, N.Y. 10547 (US); Meyerson, Bernhard S., Yorktown Heights, N.Y. 10598 (US); Stork, Johannes M.C., Yorktown Heights, N.Y. 10598 (US)
(74) Representative: Schäfer, Wolfgang, Dipl.-Ing.

(56) References cited:
- EP-A- 0 132 326
- AT-B- 370 561
- DE-A- 2 513 459
- US-A- 3 838 440

## Description

The present invention relates to complementary bipolar and MOS integrated circuit semiconductor devices and processes, and more particularly to a semiconductor device with a P- well, and a fabrication method for forming a buried P+ subcollector with a self-aligned reachthrough using a low temperature expitaxial and planarization technique.

U.S. -A- 3,838,440 issued September 24, 1974 to McCaffrey et al entitled A MONOLITHIC MOS/BIPOLAR INTEGRATED CIRCUIT STRUCTURE describes an integrated circuit with a MOS device including an N+ region formed by a combination of epitaxial growth and ion implantation which provides a pocket filled with higher resistivity, lightly doped N type material. Over extended growth and etch back are not shown or discussed in the patent.

The publication FORMATION OF PLANAR n+ POCKETS IN GaAs FOR MIXER DIODE FABRICATION, by James A. Griffin et al, IEEE Transactions on Electron Devices, Vol. Ed-31, No. 8, August 1984, pages 1096-1099 describes a technique to produce thick n+ "pockets" of highly conducting epitaxial material on the substrate surface in semi-insulating GaAs bulk material. The pockets are formed by the growth of a liquid-phase epitaxial (LPE) layer into holes which had been etched into the substrate and surface uniformity is obtained by chemo-mechanically polishing the substrate surface.

An object of the present invention is to provide a buried P+ subcollector with a self-aligned reachthrough for an integrated circuit device. Another object of the present invention is to provide a fabrication method for forming a buried P+ subcollector with a self-aligned reachthrough using a low temperature epitaxial and planarization technique.

A further object of the present invention is to provide a complementary bipolar or CMOS device having a P- well with a buried P+ layer with a free, self-aligned P+ reachthrough.

Still another object of the present invention is to provide a UHV/CVD epitaxial process to form a buried P+ subcollector isolated P- well with a free, self-aligned P+ reachthrough at the edge of the well for formation of a subcollector contact. Another object of the present invention is to provide a bipolar vertical PNP transistor structure with a P- well and buried P+ layer.

One way of carrying out the invention is described in more detail below with reference to the drawings in which:
- Fig. 1: is a schematic cross-sectional view of a semiconductor device structure according to the present invention including a substrate layer, a subcollector layer, an epitaxial layer and a well region disposed in said epitaxial and subcollector layers.
- Fig. 2: is a schematic cross-sectional view of the semiconductor device structure of Fig. 1 after subsequent deposition and etching of an epitaxial layer.
- Fig. 3: is a schematic cross-sectional view of the semiconductor device structure of Fig. 2 after subsequent planarization.

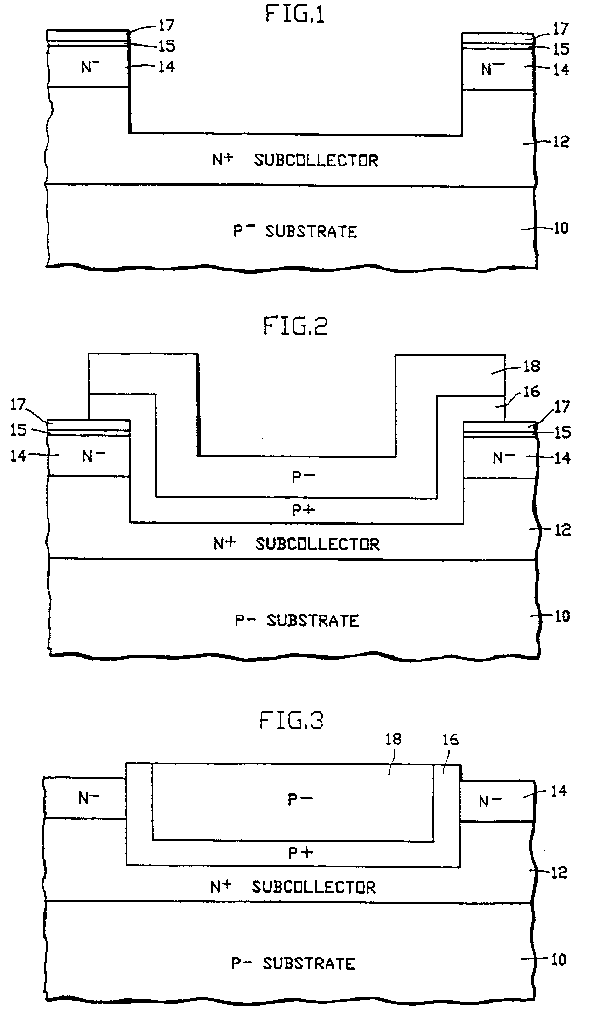

Referring to Fig. 1, a P- semiconductor material substrate 10 has been ion-implanted with N-type dopants to form an N+ subcollector layer 12. A typical process used to do this would be to implant 1.5 x 10¹⁶ 1/cm² Arsenic ions through a screen oxide and then give the implant a long oxidizing anneal for 30 minutes at 1100°C in steam. This is followed by an anneal in Argon to further remove implant damage and drive the arsenic dopant ions deeper into the P substrate. Next a lightly doped N- epitaxial layer 14 is grown on the N+ subcollector layer 12. Typical thicknesses and doping concentrations are 1.2µm and 5 x 10¹⁵ 1/cm³. This forms the blanket collector which is the starting place for many bipolar processes. As such, it is well practiced and characterized. The objective of the present invention is to not alter this starting material and use epitaxial techniques to deposit a subcollector and collector layer for a complementary device.

To form a P- well region, a pad oxide 15 of 10nm is grown on the N- epi layer 14 and a 200nm layer of nitride 17 is then deposited on top of the layer oxide. A photoresist etch mask is used to pattern the P- well region. A reactive ion etch is performed through the dielectric oxide and nitride layers, through the epitaxial layer 14 and stopping in sub-collector layer 12. The etched P- well region is shown in Fig. 1. By the end of a typical bipolar process, the N+ subcollector can be as wide as 1.5 micrometers.

The depth of the P well is limited to the thickness of the N- epi (1.2 µm plus some percentage of the 1.5 µm wire N+ subcollector. Thus, the P well must be less than 2.7 µm in the present discussed embodiment. A total depth of 1.5 µm is selected.

In Fig. 2, a layer of low temperature expitaxial material is grown over the structure of Fig. 1 using ultra-high vacuum/chemical vapor depositions such that the epitaxial layer extends above the surface of layer 14 and includes a P+ heavily doped layer 16 and a lightly P- doped surface layer 18. Layer 16 may also include a more lightly doped layer directly in contact with layer 14 to improve yield from defects occurring due to immediately growing a P+ epitaxial layer on top of a heavily doped N+ layer. The total thickness of layers 16 and 18 should be equal to the depth of the P- well to guarantee the most planar structure. Layer 16 provides the low resistance contact to the collector region and should be as heavily doped and wide as possible. Layer 18 is the collector region and its thickness is determined by the diffusion of layer 16 during the entire process. With low temperature processing, layer 18 can be less than 0.4 µm. The low temperature processing includes, 700°C high pressure oxidation for all oxidation steps, and RTA anneals for any defect annealing steps. With more standard and conventional processing, the thickness of layer 18 must be at least 1.2 µm. Using a mix of the two processing approaches, a 0.8 µm layer 18 thickness and a 0.7 µm layer 16 thickness is achieved in the embodiment.

Several methods may be possible to establish layers 16 and 18. In the preferred method they should be deposited by the UHV/CVD technique. This method has achieved chemical concentrations of boron greater than 5 x 10²¹ 1/cm³. In addition very lightly doped levels of boron are also easily achievable. The UHV/CVD technique is also capable of incorporating Ge to compensate the strain produced by the heavily doped boron layers. For example, if the boron concentration was 2 x 10²¹ in layer 16, a desirable germanium concentration would be five times the boron concentration or approximately 20% Ge. This ability to dope films heavily with boron and compensate the stress makes it feasible to have a thin low resistance subcollector in layer 16. A second approach would be to use a reduced pressure selective epitaxial technology. Reduced pressure systems have achieved 1 x 10²⁰ 1/cm³ concentrations of boron at 900° which is adequate. The reduced pressure systems also have selective growth capability. The approach in the selective reduced pressure case would be to overgrow and planarize so that defects are reduced and final structure is planar. The selective approach is simpler in that the masking and etching step shown in Fig. 2 is not required. The preferred method is the UHV/CVD technique because of the control of dopant concentration over a wide range; which is non selective.

The epitaxial layers 16 and 18 are patterned with a mask larger than the described P- well region and reactive ion etched to provide the structure of Fig. 2. The mask overlap is between 3-5 µm outside of the initial P- well mask. The purpose is to prevent "breaking" high aspect silicon structures during the polish. It is a well known procedure for those skilled in the art of chem-mech polish.

The structure of Fig. 2 is planarized using chemical-mechanical techniques to provide the structure of Fig. 3 including a planar P- well region 18 with a P+ subcollector contact ring 16 around the vertical transistor device.

The structure of Fig. 3 is particularly suited to complementary bipolar technology where a blanket subcollector for the NPN structure is used and where integrating the PNP structure is desired with as little modification of existing NPN processes. The present invention provides advantages over forming a P- well by Ion/Implant steps. Ion/Implant has several deficiencies, the most notable being that in the NPN process, the epi-thickness is selected to be as thin as possible. The P- well must be ion-implanted on top of the N+ subcollector and still leave room for the formation of the PNP base. If there is sufficient room to do this and achieve a low resistance subcollector, then the original epi-thickness was much too thick. The present invention does not have that problem. Because the N-epi and a large portion of the N+ subcollector can be removed by the etch step, the PNP profile and NPN profile are no longer tightly coupled. Each can be independently optimized. The NPN profile is optimized by the N- epitaxial layer thickness and the PNP profile is optimized by the thickness and doping concentrations of layer 18 and layer 16.

Another advantage of the present invention is the non-critical nature of the junction quality at the N+ subcollector/P++ P- well layer. The devices are not isolated by that junction but by a deep trench in the usual bipolar process. As long as the epitaxial crystalline quality remains, there are no limits on the dopant concentrations.

A further advantage of the described invention is the provision of reduced collector resistance by the self-aligned reachthrough.

## Claims

1. A method for fabricating an integrated circuit device having a subcollector element (16), including a self-aligned subcollector reach-through contact and a well (18) comprising the steps of:
Step A. Implanting a semiconductor substrate (10) surface with impurities to form a doped blanket subcollector region (12) on said substrate (10),
Step B. Disposing a first layer (14) of epitaxial material on said doped substrate (10) surface to form a collector region,
Step C. Masking, patterning and etching a well recess through said collector region and into said blanket subcollector region (14, 12),
Step D. Forming a layer of low temperature epitaxial material (16, 18) over said collector region and blanket subcollector region (14, 12) to fill in said well recess, said low temperature epitaxial material extending above and over said surface level of first layer of epitaxial material (14) on said substrate (10), said low temperature epitaxial material including a first, heavily doped stratum (16) disposed beneath a second, lightly doped stratum (18) wherein said first heavily doped stratum (16) forms said subcollector element (16) and extends over and in contact with said doped blanket subcollector region (12) on said substrate (10) beneath said well recess, in contact with the sides of said well recess and over said surface level of said first layer of epitaxial material (14),
Step E. Masking said layer of low temperature epitaxial material (16, 18) with a mask having an aperture larger than said well recess mask, then patterning and etching said low temperature expitaxial material (16, 18), and
Step F. Mechanically polishing said structure surface to planarize said low temperature epitaxial layer (16, 18) and said first layer of epitaxial material (14) wherein said first heavily doped stratum (16) of said low temperature epitaxial layer forms a contact for said subcollector region (12) that extends to said planarized surface.

2. The method for fabricating an integrated circuit device according to claim 1 wherein said Step A includes implanting a P- material semiconductor substrate (10) surface with arsenic ions and annealing said implanted substrate to form an N+ subcollector region (12).

3. The method for fabricating an integrated circuit device according to claim 1 or 2 wherein Step B includes growing a layer of lightly doped N-epitaxial material (14) on said N+ subcollector layer (12) to form a collector region (14).

4. The method for fabricating an integrated circuit device according to claim 3 wherein Step C includes growing an oxide layer (15) on said layer (14) of N- epitaxial material, depositing a nitride layer (17) on said oxide layer (15), depositing and patterning a layer of photoresist material to form a mask, and reactive ion etching said oxide layer (15) said nitride layer (17), said N- epitaxial collector (14) region and said N+ subcollector region (12) through said photo-resist mask to form said well recess.

5. The method for fabricating an integrated circuit device according to anyone of the claims 1 to 4 wherein Step D includes depositing said low temperature epitaxial material (16, 18) with boron doping by ultra-high vacuum chemical vapor deposition.

6. An integrated circuit device structure having a subcollector (12) and a well (18) with a self-aligned subcollector reachthrough contact (16) comprising
a semiconductor substrate (10) of first conductivity type,
a first doped, opposite conductivity type semiconductor layer having a first doping concentration disposed on said substrate to provide a blanket subcollector region (12),
a second doped, opposite conductivity type semiconductor layer (14) disposed on said sub-collector layer to form a collector region (14),
a well structure recessed through said second doped layer and into said first doped layer, said well structure including therein low temperature expitaxial material (16, 18) composed of a stratum (16) of heavily doped semiconductor material disposed as a subcollector on top of said blanket subcollector region (12) and extending up to the surface level of said collector region (14) and a stratum (18) of lightly doped semiconductor material in said well and disposed on said heavily doped stratum (16) and coplanar with said surface level of said collector region (14) to form a well wherein said heavily doped stratum (16) provides a contact from said subcollector region (12) to said surface of said collector region (14).

7. The integrated circuit device structure according to claim 6 wherein said semiconductor substrate (10) is composed of P- material,
said first doped layer (12) is an N+ subcollector and said second doped layer (14) is an N- collector for a CMOS device.

## Patentansprüche

1. Verfahren zur Herstellung eines Bauelementes mit integrierten Schaltkreisen mit einem Subkollektorelement (16), das einen selbstjustierten, durchführenden Subkollektor-Kontakt und eine Wanne (18) beinhaltet, mit den Schritten:
Schritt A. Implantieren der Oberfläche eines Halbleitersubstrats (10) mit Fremdatomen, um eine ganzflächige dotierte Subkollektorzone (12) auf dem Substrat (10) zu erzeugen,
Schritt B. Anordnen einer ersten Schicht (14) aus epitaxialem Material auf der dotierten Substratoberfläche (10), um eine Kollektorzone zu erzeugen,
Schritt C. Maskieren, Strukturieren und Ätzen einer Wannen-Vertiefung durch die Kollektorzone hindurch und in die ganzflächige Subkollektorzone (14, 12) hinein,
Schritt D. Bilden einer Schicht aus Niedertemperatur-Epitaxialmaterial (16, 18) über der Kollektorzone und der ganzflächigen Subkollektorzone (14, 12), um die Wannenvertiefung aufzufüllen, wobei sich das Niedertemperatur-Epitaxialmaterial auf und über dem Oberflächenniveau der ersten Schicht (14) aus Epitaxialmaterial auf dem Substrat (10) erstreckt und das Niedertemperatur-Epitaxialmaterial eine erste, unterhalb einer zweiten, schwach dotierten Schichtlage (18) angeordnete, stark dotierte Schichtlage (16) beinhaltet, wobei die erste, stark dotierte Schichtlage (16) das Subkollektorelement (16) bildet und sich über der dotierten, ganzflächigen Subkollektorzone (12) auf dem Substrat (10) unterhalb der Wannenvertiefung und in Kontakt mit ihr, in Kontakt mit den Seiten der Wannenvertiefung und über das Oberflächenniveau der ersten Schicht (14) aus Epitaxialmaterial erstreckt,
Schritt E. Maskieren der Schicht aus Niedertemperatur-Epitaxialmaterial (16, 18) mit einer Maske, die eine größere Öffnung als die Maske für die Wannenvertiefung aufweist, dann Strukturieren und Ätzen des Niedertemperatur-Epitaxialmaterials (16, 18) und
Schritt F. Mechanisches Polieren der Strukturoberfläche, um das Niedertemperatur-Epitaxialmaterial (16, 18) und die erste Schicht aus Epitaxialmaterial (14) zu planarisieren, wobei die erste, stark dotierte Schichtlage (16) der Niedertemperatur-Epitaxialschicht einen Kontakt für die Subkollektorzone (12) bildet, der sich bis zu der planarisierten Oberfläche erstreckt.

2. Verfahren zur Herstellung eines Bauelementes mit integrierten Schaltkreisen nach Anspruch 1, wobei der Schritt A das Implantieren der Oberfläche eines Halbleitersubstrats (10) aus p⁻-Material mit Arsenionen und das Tempern des implantierten Substrats beinhaltet, um eine n⁺-Subkollektorzone (12) zu bilden.

3. Verfahren zur Herstellung eines Bauelementes mit integrierten Schaltkreisen nach Anspruch 1 oder 2, wobei der Schritt B das Aufwachsen einer Schicht aus schwach dotiertem n⁻-Epitaxialmaterial (14) auf der n⁺-Subkollektorschicht (12) beinhaltet, um eine Kollektorzone (14) zu bilden.

4. Verfahren zur Herstellung eines Bauelementes mit integrierten Schaltkreisen nach Anspruch 3, wobei der Schritt C das Aufwachsen einer Oxidschicht (15) auf der Schicht (14) aus n⁻-Epitaxialmaterial, das Aufbringen einer Nitridschicht (17) auf der Oxidschicht (15), das Aufbringen und Strukturieren einer Schicht aus Photoresistmaterial zur Bildung einer Maske und das reaktive Ionenätzen der Oxidschicht (15), der Nitridschicht (17), der n⁻-Epitaxial-Kollektorzone (14) und der n⁺-Subkollektorzone (12) durch die Photoresistmaske hindurch beinhaltet, um die Wannenvertiefung zu bilden.

5. Verfahren zur Herstellung eines Bauelementes mit integrierten Schaltkreisen nach einem der Ansprüche 1 bis 4, wobei der Schritt D das Aufbringen des Niedertemperatur-Epitaxialmaterials (16, 18) mit einer Bordotierung durch eine chemische Gasphasenabscheidung in Ultrahochvakuum beinhaltet.

6. Bauelementstruktur mit integrierten Schaltkreisen, die einen Subkollektor (12) und eine Wanne (18) mit einem selbstjustierten, durchführenden Subkollektor-Kontakt (16) aufweist, mit
einem Halbleitersubstrat (10) eines ersten Leitfähigkeitstyps,
einer auf dem Substrat angeordneten, ersten dotierten Halbleiterschicht vom entgegengesetzten Leitfähigkeitstyp mit einer ersten Dotierkonzentration, um eine ganzflächige Subkollektorzone (12) bereitzustellen,
einer auf der Subkollektorschicht angeordneten, zweiten dotierten Halbleiterschicht (14) vom entgegengesetzten Leitfähigkeitstyp, um eine Kollektorzone (14) zu bilden,
einer durch die zweite dotierte Schicht hindurch und in die erste dotierte Schicht hinein vertieften Wannenstruktur, wobei die Wannenstruktur Niedertemperatur-Epitaxialmaterial (16, 18) beinhaltet, das aus einer Schichtlage (16) aus stark dotiertem Halbleitermaterial, das als Subkollektor oben auf der ganzflächigen Subkollektorzone (12) angeordnet ist und sich bis auf das Oberflächenniveau der Kollektorzone (14) erstreckt, und einer aus schwach dotiertem Halbleitermaterial in der Wanne bestehenden und auf der stark dotierten Schichtlage (16) sowie koplanar mit dem Oberflächenniveau der Kollektorzone (14) angeordneten Schichtlage (18) zusammengesetzt ist, um eine Wanne zu bilden, wobei die stark dotierte Schichtlage (16) einen Kontakt von der Subkollektorzone (12) zur Oberfläche der Kollektorzone (14) bereitstellt.

7. Bauelementstruktur mit integrierten Schaltkreisen nach Anspruch 6, wobei das Halbleitersubstrat (10) aus p⁻-Material besteht,
die erste dotierte Schicht (12) einen n⁺-Subkollektor darstellt und die zweite dotierte Schicht (14) einen n⁻-Kollektor für ein CMOS-Bauelement darstellt.

## Revendications

1. Procédé de fabrication d'un dispositif à circuit intégré avec un élément de sous-collecteur (16) ayant un contact à alignement automatique avec un sous-collecteur et un puits (18), comprenant les étapes de:
Etape A. Implanter la surface d'un substrat semiconducteur (10) d'impuretés pour former une région de sous-collecteur de couverture dopée (12) sur ledit substrat (10),
Etape B. Disposer une première couche (14) de matériau épitaxique sur ladite surface de substrat dopée (10) pour former une région de collecteur,
Etape C. Masquer, configurer et décaper un évidement en forme de puits dans ladite région de collecteur jusqu'à ladite région de sous-collecteur de couverture (14, 12),
Etape D. former une couche épitaxique de faible température (16, 18) sur lesdites régions de collecteur et région de sous-collecteur de couverture (14, 12) pour remplir ledit évidement en forme de puits, ledit matériau épitaxique de faible température se prolongeant au-dessus et sur ledit niveau de surface de première couche de matériau épitaxique (14) sur ledit substrat (10), ledit matériau épitaxique de faible température comprenant une première strate fortement dopée (16) disposée dessous une deuxième strate légèrement dopée (18), dans laquelle ladite première strate fortement dopée (16) forme ledit élément de sous-collecteur (16) et se prolonge sur ladite région de sous-collecteur de couverture dopée (12) en faisant contact avec celle-ci, sur le substrat 10 dessous ledit évidement en forme de puits, en contact avec les côtés dudit évidement en forme de puits et sur ledit niveau de surface de ladite première couche de matériau épitaxique (14),
Etape E. Masquer ladite couche de matériau épitaxique de faible température (16, 18) avec un masque ayant une ouverture plus grande que ledit masque de l'évidement en forme de puits, puis configurer et décaper ledit matériau épitaxique de faible température (16, 18), et
Etape F. Polir mécaniquement ladite surface de structure pour aplanir ladite couche épitaxique de faible température (16, 18) et ladite première couche de matériau épitaxique (14) , dans laquelle ladite première strate fortement dopée (16) de ladite couche épitaxique de faible température forme un contact pour ladite régions de sous-collecteur (12) qui se prolonge jusqu'à la surface aplanie.

2. Procédé de fabrication d'un dispositif à circuit intégré selon la revendication 1, dans lequel ladite étape A comprend l'implantation de la surface d'un substrat semi-conducteur de matériau P- (10) d'ions d'arsenic et le recuit dudit substrat implanté pour former une région de sous-collecteur N+ (12).

3. Procédé de fabrication d'un dispositif à circuit intégré selon les revendications 1 ou 2, dans lequel l'Etape B comprend la croissance d'une couche de matériau épitaxique légèrement dopée N- (14) sur ladite couche de sous-collecteur N+ (12) pour former une région de collecteur (14).

4. Procédé de fabrication d'un dispositif à circuit intégré selon la revendication 3, dans lequel l'Etape C comprend la croissance d'une couche d'oxyde (15) sur ladite couche (14) de matériau épitaxique N-, le dépôt d'une couche de nitrure (17) sur ladite couche d'oxyde (15), le dépôt et la configuration d'une couche de matériau photorésistant pour former un masque, et le décapage par ions réactifs de ladite couche d'oxyde (15), de ladite couche de nitrure (17), de ladite région de collecteur épitaxique N- (14) et de ladite région de sous-collecteur N- (12) et de ladite région de sous-collecteur N+ (12) par ledit masque photorésistant pour former ledit évidement en forme de puits.

5. Procédé de fabrication d'un dispositif à circuit intégré selon l'une quelconque des revendications 1 à 4, dans lequel l'Etape D comprend le dépôt dudit matériau épitaxique de faible température (16, 18) avec dopage au bore par un dépôt chimique en phase vapeur à vide très poussé.

6. Structure de dispositif à circuit intégré ayant un sous-collecteur (12) et un puits (18) ayant un contact (16) à alignement automatique avec un sous-collecteur, comprenant:
un substrat semi-conducteur (10) d'un premier type de conductivité,
une première couche semi-conductrice de type de conductivité opposé, dopée ayant une première concentration de dopage disposée sur ledit substrat pour fournir une région de sous-collecteur de couverture (12),
une deuxième couche semi-conductrice de type de conductivité opposé, dopée (14) disposée sur ladite couche de sous-collecteur pour former une région de collecteur (14),
une structure de puits évidée dans ladite deuxième couche dopée jusque dans ladite première couche dopée, ladite structure de puits comportant un matériau épitaxique de faible température (16, 18) formé d'une strate (16) de matériau semi-conducteur fortement dopé disposé comme sous-collecteur au sommet de ladite région de sous-collecteur de couverture (12) et s'étendant jusqu'au niveau de surface de ladite région de collecteur (14), et d'une strate (18) de matériau semi-conducteur légèrement dopé dans ledit puits et disposée sur ladite strate fortement dopée (16) et co-planaire avec ledit niveau de surface de ladite région de collecteur (14) pour former un puits, dans laquelle ladite strate fortement dopée (16) fournit un contact allant de ladite région de sous-collecteur (12) jusqu'à ladite surface de ladite région de collecteur (14).

7. Structure de dispositif à circuit intégré selon la revendication 6, dans laquelle ledit substrat semi-conducteur (10) est composé d'un matériau P-,
ladite première couche dopée (12) est un sous-collecteur N+ et ladite deuxième couche dopée (14) est un collecteur N- pour un dispositif CMOS.
